Europäisches Patentamt

European Patent Office

Office européen des brevets

(19)

(11) EP 0 486 699 B1

# (12) EUROPEAN PATENT SPECIFICATION

(45) Date of publication and mention
of the grant of the patent:
**09.09.1998 Bulletin 1998/37**

(21) Application number: **91910632.8**

(22) Date of filing: **11.06.1991**

(51) Int Cl.6: **H01L 27/118**

(86) International application number:
**PCT/JP91/00784**

(87) International publication number:
**WO 91/20094 (26.12.1991 Gazette 1991/29)**

## (54) **SEMICONDUCTOR DEVICE**

HALBLEITERANORDNUNG

DISPOSITIF A SEMI-CONDUCTEURS

(84) Designated Contracting States:
**DE FR GB NL**

(30) Priority: **15.06.1990 JP 157035/90**
**15.06.1990 JP 157036/90**

(43) Date of publication of application:
**27.05.1992 Bulletin 1992/22**

(73) Proprietor: **SEIKO EPSON CORPORATION**
**Shinjuku-ku Tokyo (JP)**

(72) Inventors:
 • **HIRABAYASHI, Yasuhisa**
 **aNagano-ken 392 (JP)**
 • **SAKUDA, Takashi**
 **Nagano-ken 392 (JP)**
 • **OOKAWA, Kazuhiko**
 **Nagano-ken 392 (JP)**

 • **OGUCHI, Yasuhiro**
 **Nagano-ken 392 (JP)**

(74) Representative: **Hoffmann, Eckart, Dipl.-Ing. et al**
**Patentanwalt,**
**Bahnhofstrasse 103**
**82166 Gräfelfing (DE)**

(56) References cited:
**EP-A- 280 176        JP-A- 2 177 456**
**JP-A-60 017 930       JP-A-60 254 631**

 • **IBM TECHNICAL DISCLOSURE BULLETIN, vol.**
 **32, no. 5B, October 1989, New York US, pp.**
 **277-278; 'Gate-array cell to improve circuit**
 **density chip'**
 • **PATENT ABSTRACTS OF JAPAN vol. 10, no.121**
 **( E-401 ) & JP-A-60 254 631 ( FUJITSU KK ) 16**
 **December 1985**

## Description

Technical Field:

The present invention relates generally to a semiconductor device in which basic cells including a plurality of MISFETs (metal insulator semiconductor field-effect transistors) are continuously formed, and more particularly, to a semiconductor device capable of constructing a CMOS large-scale integrated circuit by a master slice method.

Background Arts:

Turning to FIG. 11, there is shown a semiconductor device based on complementary metal-oxide semiconductor (CMOS) field-effect transistors manufactured by a generally employed master slice method. The semiconductor device depicted in this Figure is formed by a gate array method on the basis of cells each consisting of two P-channel MOSs and two N-channel MOSs. A static RAM (SRAM) circuit is constructed by employing the semiconductor device described above.

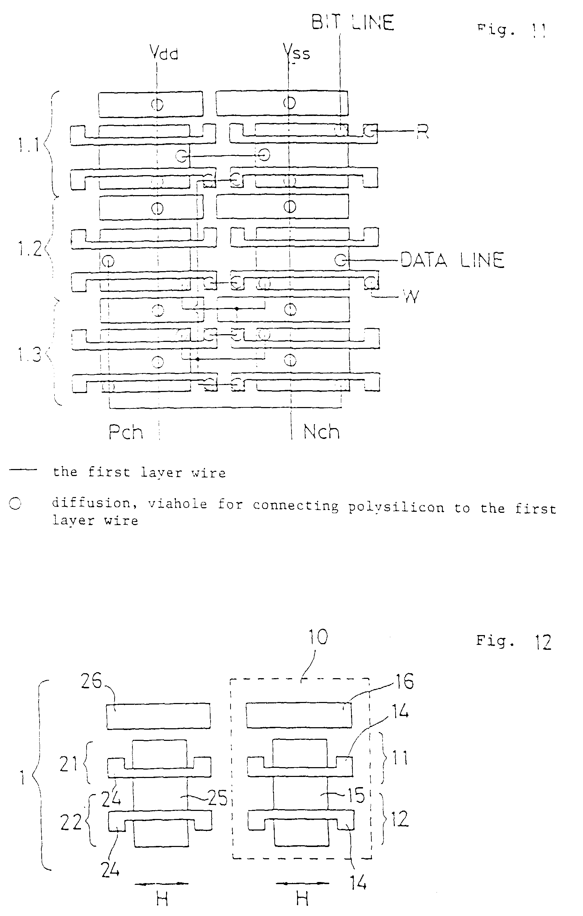

FIG. 12 illustrates a cell 1 on which this semiconductor device is based. In this cell 1, a high concentration N-type diffused layer is formed by introducing an impurity, wherein a mask is a polysilicon gate 14 formed in a P-type well 10 on the semiconductor device. This high concentration N-type diffused layer 15 and the gate electrode 14 constitute two N-channel MOSs (N-MOSs) 11, 12. The gate electrodes 14 of these two N-MOSs 11, 12 are disposed in parallel and have the same orientation. The MOSs 11, 12 share the N-type diffused layer 15 with each other. This region is therefore used in common as a source or drain region. Further, a stopper layer 16, i.e., a high concentration P-type diffused layer, is formed in parallel with these MOSs 11, 12 in a region adjacent to a cell neighboring to the cell 1. This stopper layer 16 is a diffused layer assuming a substantially rectangular shape. The stopper layer is formed for separating the N-MOSs of the adjacent cells and preventing a channel formation when an inter-cell semiconductor surface is inverted. A power supply line is connected via this stopper layer 16 to a substrate, thereby reducing a difference between a substrate potential and a power supply potential. A latch-up of a parasitic transistor formed in the MOS is prevented.

On the other hand, the cell 1 is formed with two P-channel MOSs (P-MOSs) 21, 22 in symmetry with the N-MOSs 11, 12. In association with the P-MOSs 21, 22, as in the case of the N-MOSs 11, 12, a high concentration P-type diffused layer 25 is formed with a polysilicon gate electrode 24 serving as a mask. Owing to this diffused layer 25 and the gate electrode 24, the two P-MOSs 21, 22 are formed in parallel. As in the case of the N-MOSs 11, 12, the P-MOSs 21, 22 share a source or drain region with each other. In association with these P-MOSs 21, 22, for the same purpose as that of the stopper layer 16, a stopper layer 26 is formed of a high concentration N-type diffused layer.

As described above, one basic cell 1 comprises the two N-MOSs 11, 12, the two P-MOSs 21, 22 and stopper layers 16, 26. In the semiconductor device based on the master slice method, the basic cells are continuously formed at constant intervals. Those basic cells are connected with wires of Al and the like, thus obtaining a desired circuit. The device depicted in FIG. 11 is one example of this arrangement. A SRAM is configured by the gate array method in which designing is effected in conformity with vertical/lateral fixed wiring rules. The following are problems inherent in the conventional complementary semiconductor device in which the P-MOSs and the N-MOSs are continuously formed. Even when a circuit module of a data switch of the above-described SRAM is constructed of unitary elements of N-MOSs, there is no alternative but to use one basic cell in terms of designing the circuit. Taking the wiring rules into consideration, it is difficult to largely change an area of the P-MOS and N-MOS, i.e., a channel width. For this reason, an operating time of the circuit is determined by the P-MOS whose response time is slow.

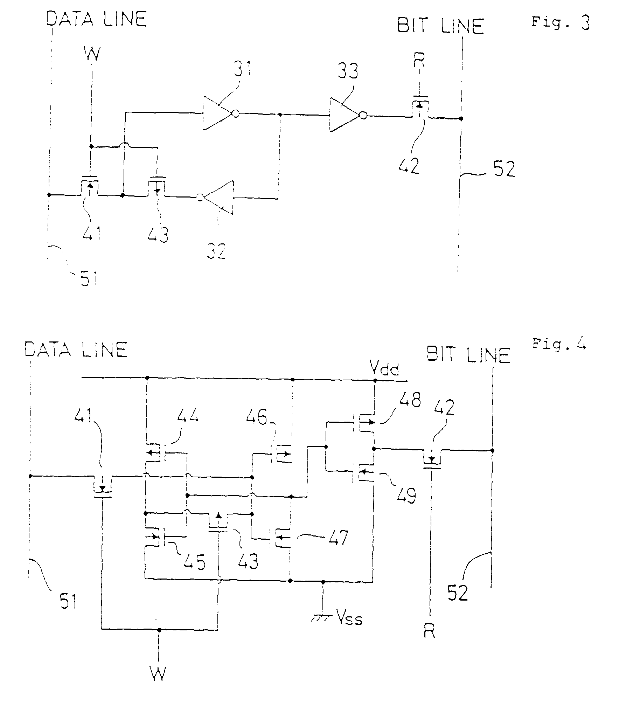

FIGS. 3 and 4 show a circuit of the SRAM in this embodiment. The SRAM in this embodiment is a 9-element-based logic circuit in which the N-MOS serves as a transmission gate. The transmission gates provided both on the reading side and on the writing side of this circuit are constructed of N-MOSs 41, 42. If the circuit in which the gates are composed of unitary elements of N-MOSs is configured by the conventional complementary semiconductor device given above, as illustrated in FIG. 11, three pieces of basic cells, viz., an area of 12 elements is required for the 9-element-based circuit.

On the other hand, the following relation about the operating time of the semiconductor device is established:

$$tr = 4 \times C / (\beta \times H \times Vdd) \tag{1}$$

where tr is the response time indicating a rise or decay time of the MOS, C is the load capacity indicating a capacity of the MOS itself and a capacity of wires parasitic to the MOS, H is the channel width, Vdd is the power supply potential, and $\beta$ is the current amplification rate per unit length of the MOS. The current amplification rate of the P-MOS is approximately a half or a third the current amplification rate of the N-MOS. Namely, if the channel widths H are substantially equal, the response time tr of the P-MOS is approximately twice or three times as large as that of the N-MOS. For instance, in the conventional complementary semiconductor device, an inverter is composed of the P-MOS and the N-MOS. In this case, because of the channel widths H being equal, a rise time of this inverter is required to be approximately twice or three times the decay time. Hence, in the circuit where a plurality of inverters are connected, the operating time of the device is conditioned by the response time of the P-MOSs.

A semiconductor device according to the pre-characterizing clause of claim 1 is disclosed in EP-A-0 280 176. In this prior art, a gate contact portion of the sub-MISFET is disposed adjacent to the stopper layer on the side opposite to the side at which gate contact portions of the main MISFETs are located.

The document IBM Technical Disclosure Bulletin, vol. 32, no. 5B, Oct. 1989, pp. 277-278, discloses a gate array cell comprising first and second groups of three transistors each, the transistors of one group being of one conductivity type and those of the other group of the opposite conductivity type. The transistors in each group are arranged in parallel to each other and the two groups are arranged side by side. One transistor in each group is shorter than the remaining two. Each group has gate contact portions of the three transistors arranged collinear.

The document JP-A-60 254 631 discloses a gate array cell comprising first and second groups of two transistors each, the transistors of one group being of one conductivity type and those of the other group of the opposite conductivity type. The transistors in each group are arranged in parallel to each other and the two groups are arranged side by side. One transistor in each group is shorter than the other one. The gate contact portions of the two transistors in each group are arranged collinear.

The present invention aims at improving a working efficiency of a semiconductor device by ameliorating a layout of the semiconductor device based on a master slice method in which P-MOSs and N-MOSs are continuously formed and reducing an area occupied by a circuit.

This object is achieved with a semiconductor device as claimed in claim 1.

Preferred embodiments of the invention are subject-matter of the dependent claims.

A complementary semiconductor device based on a master slice method includes a plurality of basic cells continuously disposed. This basic cell consists of a single or a plurality of metal insulator semiconductor field-effect transistors (MISFETs) and a stopper layer for separating these MISFETs from MISFETs of an adjacent basic cell. The basic cells are continuously arranged so that the MISFETs and the stopper layers are parallel with each other. In such a semiconductor device, a small-sized MISFET can be formed adjacently to the stopper layer in a region neighboring to the basic cell in which the stopper layer is formed. More specifically, in addition to the stopper layer, a sub-MISFET is provided having an area smaller than that of the MISFETs constituting the basic cell in a region neighboring to the basic cell which has hitherto been occupied by the stopper layer.

The sub-MISFET may be formed in parallel with a first conductive type MISFET through a first conductive type diffused layer. The sub-MISFET may be also formed in parallel with a second conductive type MISFET through a second conductive type diffused layer. Besides, the sub-MISFETs of the respective conductive types may be also formed in parallel with the first conductive type MISFET and the second conductive type MISFET, respectively.

Where the channel regions are so oriented as to equalize the forming direction of the sub-MISFETs and the direction of the MISFETs constituting the basic cell, the wire design with respect to the sub-MISFETS can be effected by the gate array method. Those sub-MISFETs may be formed in continuation from the MISFETs constituting the basic cell by use of the same diffused layer. This diffused layer may be employed as a source or drain region common to the MISFETs and the sub-MISFET.

In the semiconductor device including the basic cell having the sub-MISFET according to the present invention, a circuit element of unitary elements can be configured by use of this sub-MISFET. Actualized, for example, is a circuit including a transmission gate constructed of a single piece of second conductive type MISFET by using the semiconductor device, formed with the second conductive type sub-MISFET, of this invention. In this case, the transmission gate is composed of the sub-MISFET, whereby a numerical quantity of the basic cells occupied by the circuit can be reduced. Therefore, unlike the conventional complementary semiconductor device, it is unnecessary to occupy the basic cells including the MISFETs of two conductive types for the circuit element actualized by the single element. For this reason, a working efficiency of the semiconductor device can be improved. Moreover, the numerical quantity of the basic cells constituting one circuit can be reduced, with the result that a length of wires for connecting the respective MISFETs can be shortened. This in turn decreases a capacity of wires parasitic to the MISFETs. The load capacity expressed by the formula (1) can he decreased. It is therefore possible to reduce the operating time of the circuit by configuring the circuit by use of the semiconductor device of this invention.

On the other hand, where a logic circuit is constructed by using the semiconductor device, formed with the first conductive type sub-MISFET, of the present invention, the operating time of the circuit can be largely decreased. To be specific, the first conductive type sub-MISFET is connected in parallel to the first conductive type MISFET, an apparent channel width can be expanded. For this reason, as expressed in the formula (1), the response time of the first conductive type one can be approximate to that of the second conductive type one. Hence, the operating time of the logic circuit configured by use of the semiconductor device of this invention can be reduced.

Brief Description of the Drawings:

FIG. 1 is a layout diagram showing a construction of an SRAM using a semiconductor device including an N-channel sub-MOS in an embodiment 1 of the present invention;

FIG. 2 is a layout diagram showing a configuration of a basic cell of the semiconductor device illustrated in FIG. 1;

FIG. 3 is a circuit diagram illustrating a logic circuit of the SRAM of FIG. 1;

FIG. 4 is a circuit diagram illustrating a circuit of the SRAM of FIG. 1;

FIG. 5 is a layout diagram showing a configuration of an output multiplexer employing the semiconductor device including a P-channel sub-MOS in an embodiment 2 of this invention;

FIG. 6 is a circuit diagram illustrating a logic circuit of the output multiplexer shown in FIG. 5;

FIG. 7 is a circuit diagram illustrating a circuit of the output multiplexer shown in FIG. 5;

FIG. 8 is a layout diagram showing a configuration of the SRAM using the semiconductor device including the N-and-P channel sub-MOSs in a third embodiment of this invention;

FIG. 9 is a circuit diagram depicting a logic circuit of the SRAM shown in FIG. 8;

FIG. 10 is a layout diagram showing a construction of the semiconductor device of this invention of FIG. 8;

FIG. 11 is a layout diagram showing a configuration of the SRAM using a conventional complementary semiconductor device; and

FIG. 12 is a layout diagram showing a configuration of the basic cell shown in FIG. 11.

Best Mode for Carrying out the Invention:

Preferred embodiments of a semiconductor device according to the present invention will hereinafter be described with reference to the accompanying drawings.

[Embodiment 1]

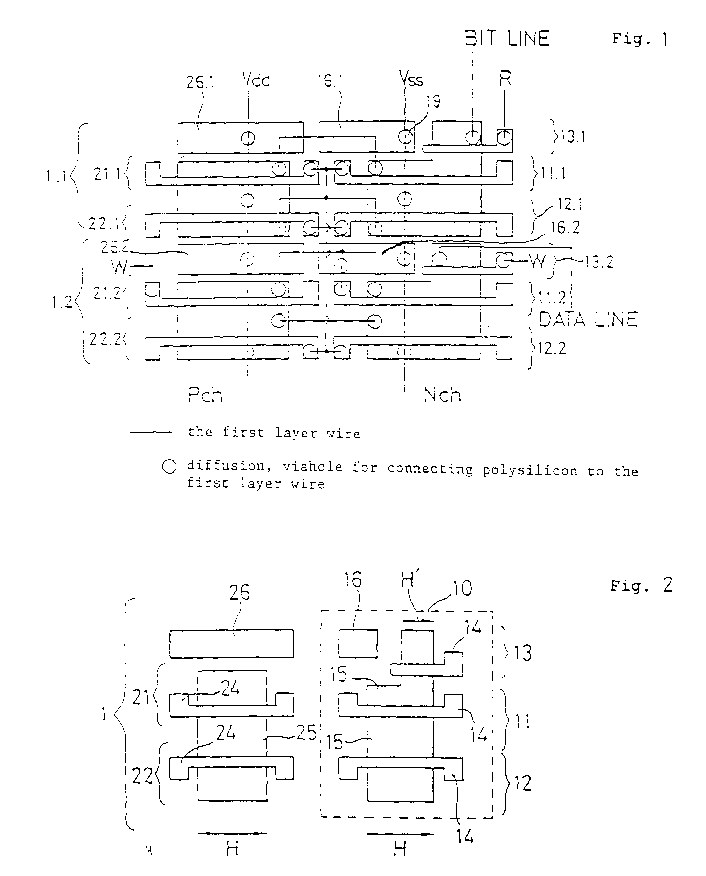

FIG. 1 illustrates a layout of an SRAM using a semiconductor device formed with an N-channel sub-MOS in an embodiment 1 of the present invention. In this embodiment, among basic cells formed in the semiconductor device, two basic cells 1.1, 1.2 constitute one memory circuit of the SRAM.

FIG. 2 shows a configuration of the basic cell constituting the semiconductor device depicted in FIG. 1. A basic cell 1 includes a P-type well 10 formed with two N-channel MOSs (N-MOSs) 11, 12. A stopper layer 16 composed of a high-concentration P-type diffused layer is formed in parallel therewith. A sub-MOS 13 is formed on the opposite side to P-channel MOS (P-MOSs) 21, 22 which will be mentioned later, with this stopper layer 16 being interposed therebetween. This sub-MOS 13 is an N-channel MOS composed of a high concentration N-type diffused layer 15 which is, as in the case of the N-MOSs 11, 12, introduced with a polysilicon gate electrode 14 serving as a mask. The sub-MOS 13 is formed in parallel with the N-MOSs 11, 12. The N-type diffused layer 15 used as a source or drain of this sub-MOS 13 is identical with an N-type diffused layer 15 for constituting the N-MOS 11 described above. A region of this N-type diffused layer 15 can be therefore used in common to the sub-MOS 13 as a region of the source or drain of the N-MOS 11. This sub-MOS 13 is formed in line with the stopper layer 16 in a region, adjacent to other basic cell, of the basic cell 1. Hence, a channel width H' of the sub-MOS 13 is approximately a half the channel width H of the N-MOSs 11, 12 which constitute the basic cell 11. As discussed above, in the device in this embodiment, the sub-MOS is incorporated into the basic cell without increasing the area of the basic cell over that of the conventional semiconductor device shown in FIG. 12.

On the other hand, two pieces of P-MOSs 21, 22 constituting the basic cell in this embodiment are, as in the case of the conventional complementary type basic cell, formed in symmetry with the two N-MOSs 11, 12. Further, a stopper layer 26 for separating the P-MOSs 21, 22 from the adjacent basic cell is also formed as in the same way with the conventional basic cell. These components are marked with the same numerals because of being identical with the conventional ones, and the description will be omitted.

As explained above, the conventional basic cell comprises two pieces of N-MOSs 11, 12, two pieces of P-MOSs 21, 22 and stopper layers 16, 26. In the semiconductor device in this embodiment, one N-channel sub-MOS 13 is added to those components to configure the basic cell 1. With this arrangement, a circuit element such as a transmission gate composed of a unitary element of N-MOS can be formed by using the sub-MOS 13.

FIGS. 3 and 4 show a circuit of the SRAM illustrated in FIG. 1. The SRAM in this embodiment is conceived as a 9-element-based memory circuit in which the N-MOS is employed as a transmission gate. In this circuit, a transmission gate 41 is at first opened based on a write enable signal W. A signal from a data line 51 is applied to an inverter 31 consisting of a P-MOS 46 and an N-MOS 47. A signal amplified by this inverter 31 is then applied to an inverter 32 constructed of a P-MOS 44 and an N-MOS 45. When the write enable signal W is turned OFF, the transmission gate composed of the N-MOS is closed, whereas a transmission gate 43 composed of a P-MOS is opened. For this reason, the signal amplified by the inverter 32 through this transmission gate 43 is applied again to the inverter 31. The information is recorded by the inverters 31, 32.

Next, when a transmission gate consisting of an N-MOS is opened in response to a read enable signal R, the information held by the inverters 31, 32 is amplified by an inverter 33 constructed of a P-MOS 48 and an N-MOS 49 and appears in a bit line 52.

In the semiconductor device in this embodiment for actualizing this circuit, the basic cells 1 shown in FIG. 2 are continuously formed vertically and laterally. These basic cells are connected through internal wiring to obtain a desired circuit. The above-mentioned circuit is, as illustrated in FIG. 1, attained with the two basic cells 1.1, 1.2. A design of internal wiring involves the use of a gate array method having a design rule in which the wires are orthogonal. At the first onset, power supply wires are arranged orthogonally to the respective MOSs. Vdd is connected to the P-MOSs, while Vss is connected to the N-MOSs. The respective power supply wires are connected through viaholes 19 to stopper layers 16.1, 16.2, 26.1, 26.2 for preventing a latch-up by a transistor parasitic to the MOS, with a drop of substrate potential.

The wires are connected to the respective MOSs contained in these cells 1.1, 1.2 to configure the SRAM. To start with, a read transmission gate 42 is formed of an N-channel sub-MOS 13.1 of the cell 1.1. Next, a P-MOS 21.1 and an N-MOS 11.1 are combined to constitute the inverter 33. A P-MOS 22.1 and an N-MOS cooperate to constitute the inverter 31. In the cell 1.2, a write transmission gate 41 is composed of a sub-MOS 31.2. A storage holding transmission gate 43 is constructed of a P-MOS 21.2. A P-MOS 22.2 and an N-MOS 12.2 are combined to constitute the inverter 32. A gate electrode of the N-MOS 11.2 of this cell is connected via the stopper layer 16.2 to a power supply Vss to separate the sub-MOS 13.2 used for the transmission gate 41 from the N-MOS 12.2 used for the inverter 32.

As explained above, the SRAM can be attained with two basic cells by use of the semiconductor device having the sub-MOSs in this embodiment. To configure such a circuit, in the conventional semiconductor device, as illustrated in FIG. 11, three pieces of cells are needed. Based on the device in this embodiment, however, as depicted in FIG. 1, the write transmission gate 41 is constructed of the sub-MOS 13.2 of one cell 1.2, while the read transmission gate 42 is constructed of the sub-MOS 13.1 of the other cell 1.1. Therefore, the 9-element-based memory circuit can be composed of the two cells.

In the circuit formed in the device in this embodiment, the N-channel MOSs are adopted for the transmission gates 41, 42. A rise time thereof is relatively short. Hence, an influence on a working time of the circuit is small even when those transmission gates 41, 42 are constructed of the sub-MOSs 13.1, 13.2 having a narrow channel width. The conventional device requires three pieces of cells for configuring the circuit in this embodiment. In a comparison with the conventional device, a wiring capacity associated with the MOSs is reduced, and a parasitic capacity is also decreased in the device according to this embodiment. An operating time of the circuit is, it can be said, decreased.

The circuit can be constructed by the cells whose number is two thirds that of the conventional semiconductor device. A working efficiency of the semiconductor device is, as a matter of course, improved. For this reason, the IC for memory can be miniaturized by employing the device in this embodiment, and a degree of integration can be also increased.

[Embodiment 2]

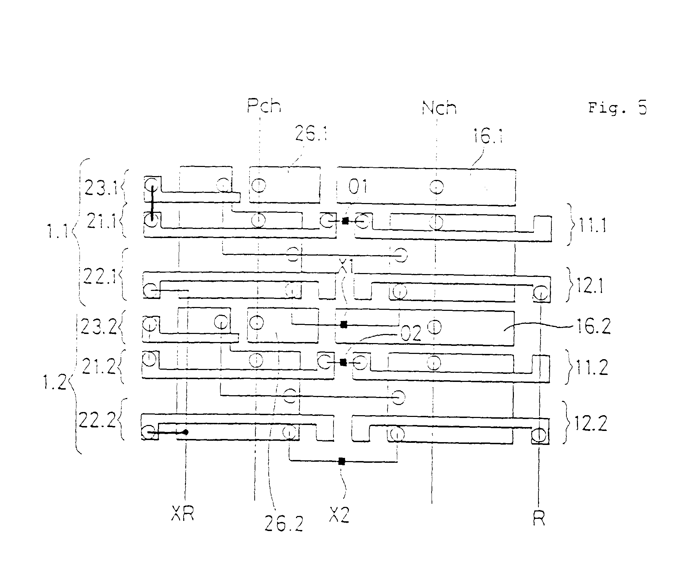

FIG. 5 illustrates the semiconductor device in this embodiment, wherein P-channel sub-MOSs relative to an embodiment 2 are formed. The circuit shown in this embodiment is 2-output multiplexer. In the semiconductor device according to this embodiment, P-channel sub-MOSs 23.1, 23.2 are, in sharp contrast with the embodiment 1, formed adjacently to stopper layers 26.1, 26.2 on the side of the P-MOS. Other basic cell configurations are the same as those in the embodiment 1, and the description will be omitted while they are marked with the like numerals. The arrangement that those basic cells are continuously formed in the semiconductor device according to this embodiment is the same with the embodiment 1.

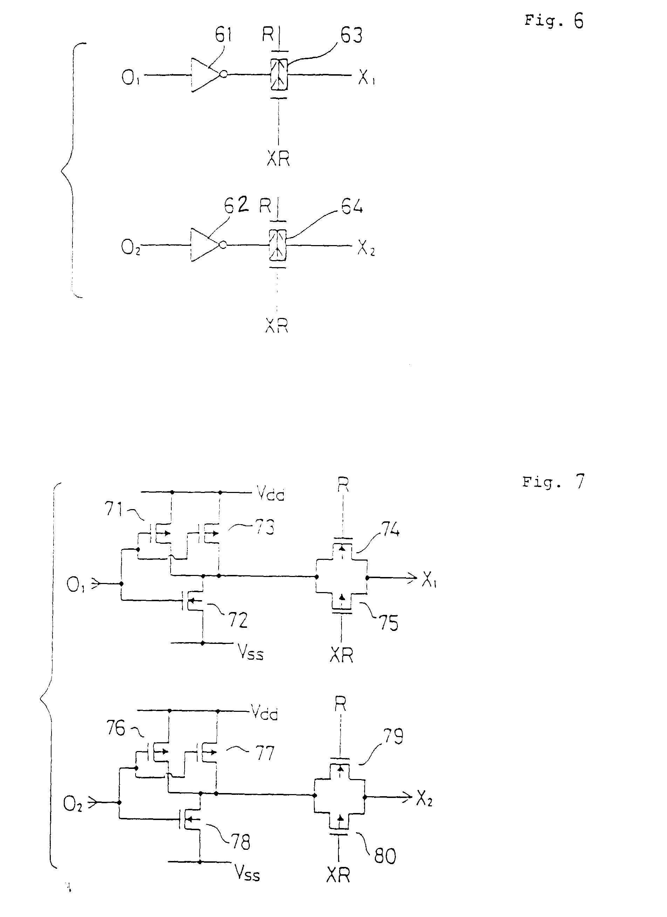

Turning to FIGS. 6 and 7, there is illustrated a circuit configured in the device in this embodiment. This circuit conceived as a 2-output multiplexer consists of: inverters 61, 62 for amplifying the outputs and transmission gates 63, 64 opened and closed by the read enable signal R and an inverted signal XR thereof. In this circuit, when the transmission gate 63 is opened by the read enable signal R and the inverted signal XR thereof, an output 01 is amplified by the inverter 61. As a result, an output signal X1 appears on the output side. The situation is the same with relations between an output 02 and an output signal X2 and between a transmission gate 64 and an inverter 62.

In the circuit described above, a signal rise time is conditioned by a response time of the P-MOS constituting the inverter. In general, the response time of the P-MOS is, as discussed above, one-half or one-third of a response time of the N-MOS. A reduction in the operating time of this circuit requires a decrease in the response time of the P-MOS. In this situation, the conventional semiconductor device takes such a countermeasure that two pieces of P-MOSs are connected in parallel. Hence, only one inverter is constructed of the basic cell including the P-MOSs and the N-MOSs by twos as the case may be.

In the device according to this embodiment, as illustrated in FIG. 7, the response time of the P-MOS is improved by connecting a P-channel sub-MOS 73 to a P-MOS 71 in parallel. With this arrangement, the inverter and the transmission gate can be composed of one cell, thereby making it possible to improve the working efficiency of the semiconductor device.

Circuitry in this embodiment will be explained referring to FIG. 7. An inverter 61 consists of the P-MOS 71, the sub-MOS 73 and the N-MOS 72 which are connected in parallel. A transmission gate 63 is constructed of an N-MOS 74 and a P-MOS 75. Similarly, an inverter 62 consists of a P-MOS 76, a sub-MOS 77 and an N-MOS 78. An N-MOS 79 and a P-MOS 80 are combined to constitute a transmission gate 64.

In the semiconductor device according to this embodiment, this circuit is, as depicted in FIG. 5, composed of two basic cells 1.1, 1.2. According to this embodiment also, as in the same way with the embodiment 1, wiring is effected using the gate array. The power supply wires Vdd and Vss are, as in the embodiment 1, connected to the stopper layers 16.1, 16. 2, 26.1, 26.2. In connection with wiring of the basic cell 1.1, gate electrodes thereof are connected so that a sub-MOS 23.1 is parallel with a P-MOS 21.1. Drains of these MOSs are connected to a drain of the N-MOS 11.1, thus constituting the inverter 61. The transmission gate 63 is composed of the P-MOS 22.1 whose source region is a drain region of the P-MOS 21.1 and the N-MOS 12.1 whose source region is a drain region of the N-MOS 11.1. In the thus configured cell, the output 01 is applied to the gate electrodes of the N-MOS 11.1 and of the P-MOS 21.1. Output signals X1 are fetched from the drains of the N-MOS 12.1 and the P-MOS 22.1, whereby a multiplexer is constructed.

The same wire arrangement with the cell 11.1 is applied to two P-MOSs 21.2, 22.2, two N-MOSs 11.2, 12.2 and further a sub-MOS 23.2 which are formed in the cell 1.2. A multiplexer is thus configured.

As discussed above, in the semiconductor device according to this embodiment, the inverter and the transmission gate can be constructed of one cell. Simultaneously, the operating time of the inverter can be reduced by use of the sub-MOSs. Therefore, the operating time can be decreased with no decrease in the working efficiency of the semiconductor device. Besides, the conventional semiconductor device involves the use of a multiplicity of basic cells to reduce the operating time, resulting in an increase in the parasitic capacity of wires for connecting the basic cells. No sufficient time reduction was given therein. Where the circuit is constituted by use of the semiconductor device in this embodiment, however, the number of basic cells does not increase, and there is caused a less amount of influence on the operating time due to an increase in the parasitic capacity of wires. A driving capability of the P-channel MOS in this circuit is enhanced, whereby a balance of logic level can be kept. AC and DC characteristics are also ameliorated.

[Embodiment 3]

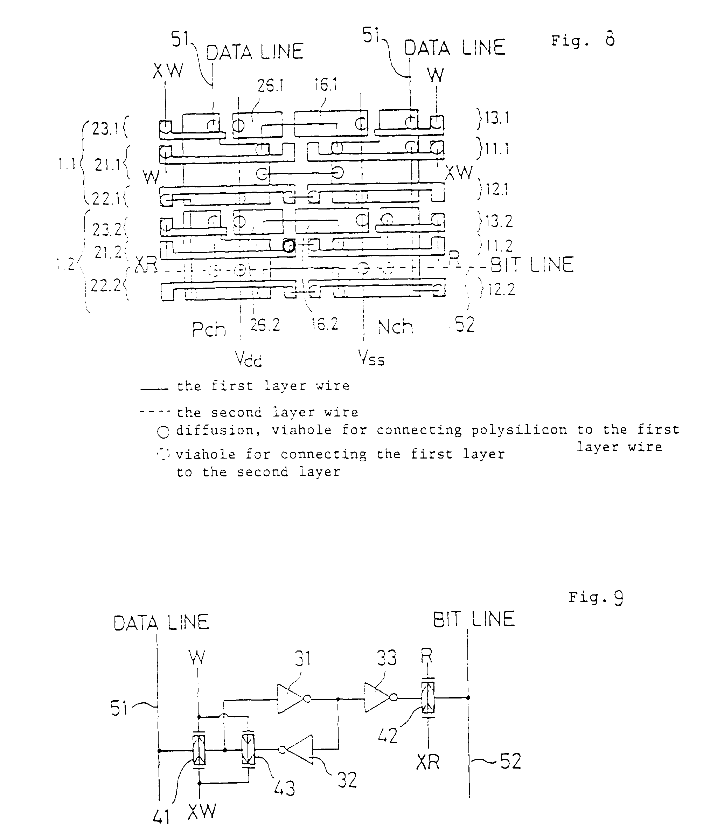

FIG. 8 illustrates the semiconductor device in this embodiment, wherein one cell includes an N-channel sub-MOS and a P-channel sub-MOS. A circuit constructed in the device according to this embodiment is the SRAM identical with that of the embodiment 1. In this embodiment, transmission gates 41, 42, 43 are constructed of the N-channel MOSs and the P-channel MOSs.

The circuit of this embodiment is demonstrated by FIG. 9. The write transmission gate used for the circuit in this embodiment is opened and closed based on a write enable signal W and an inverted signal XW thereof. The read transmission gate is opened and closed based on a read enable signal R and an inverted signal XR thereof. Operations of the inverters 31. 32, 33 and others are the same as those in the embodiment 1, and hence the description thereof is omitted while the components are marked with the like numerals.

In the semiconductor device according to this embodiment, the circuit described above is constructed of two basic cells 1.1, 1.2. More specifically, the transmission gate 41 consists of the P-channel sub-MOS 23.1 and the N-channel sub-MOS 13.1. The transmission gate 43 consists of the N-MOS 11.1 and the P-MOS 21.1. The inverter 32 is composed of the P-MOS 22.1 and the N-MOS 12.1. In the cell 1.2, the P-channel sub-MOS 23.2 and the N-channel sub-MOS 13.2 are combined to constitute the read transmission gate 42. The inverter 33 is constructed of the P-MOS 21.2 and the N-MOS 11.2. The inverter 31 is constructed of the P-MOS 22.2 and the N-MOS 12.2. An output of the transmission gate 42 is connected to a bit line 52.

Such a 12-element-based circuit has hitherto been configured by use of three pieces of cells in the conventional semiconductor device wherein the basic cell is composed of two N-MOSs and two P-MOSs. The 12-element-based circuit composed of two basic cells each having the same area is, however, attainable with the semiconductor device according to this embodiment. An integration rate of the semiconductor device can be therefore improved, and at the same moment an operating velocity can be also ameliorated by reducing the parasitic capacity of wires.

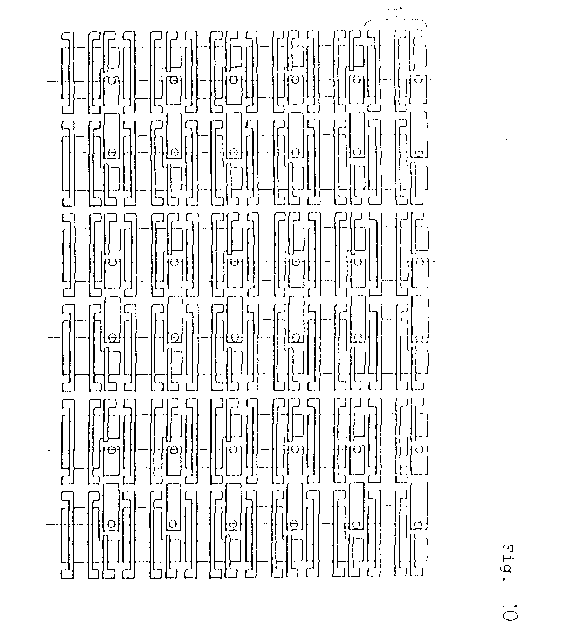

FIG. 10 depicts the semiconductor device in this embodiment , wherein the basic cells 1 are continuously formed. As described above, in the semiconductor device according to this embodiment, the basic cells 1 are consecutively formed vertically and laterally by the master slice method. A multiplicity of memory circuits are configured by inter-cell connections with the wires, thereby obtaining a single integrated circuit.

Industrial Applicability:

Employed is, as discussed above, the semiconductor device including the basic cell formed with the sub-MISFETs according to the present invention. The integration rate can be improved by enhancing the working efficiency of the semiconductor device. Besides, the operating time can be also reduced. Hence, it is possible to actualize a small-sized and high-speed I/O unit as well as the memory element having a high degree of integration by using the device in the present embodiment.

## Claims

1. A semiconductor device comprising:

   a plurality of basic cells (1) arranged adjacent to each other, wherein a predetermined circuit is configured by intra basic cell connections and inter basic cell connections, said basic cell including
   first main MISFETs (11, 12) arranged in parallel to each other,
   second main MISFETs (21, 22) arranged in parallel to each other and adjacent to said first MISFETs,
   a first stopper layer (16) disposed in parallel with said first main MISFETs to separate said first main MISFETs from first main MISFETs of another adjacent basic cell,
   a second stopper layer (26) disposed in parallel with said second main MISFETs to separate said second main MISFETs from second main MISFETs of said other adjacent basic cell, and
   a sub-MISFET (13) having an area smaller than that of said main MISFETs formed in a region adjacent to said other basic cell and adjacent to a lateral side of said first stopper layer (16),

   **characterized in that** said lateral side is distal from said second stopper layer (26), a gate contact portion of said sub-MISFET and gate contact portions of said first main MISFETs are arranged to be collinear, and a power supply contact portion of said first stopper layer (16) is provided at said lateral side of the first stopper layer (16) and arranged to be collinear with power supply contact portions of source/drain regions of said first main MISFETS.

2. The semiconductor device as set forth in claim 1, wherein said basic cell includes a first conductive type MISFET formed with at least one first conductive channel and a second conductive type MISFET formed with at least one second conductive channel, said main MISFETS are MISFETs of any one of said first and second conductive types, said first and second stopper layers are diffused layers of conductive type different from that of respective first and second main MISFETs, and said sub-MISFET is a MISFET formed with a channel having the same conductive type as that of said first main MISFETs.

3. The semiconductor device as set forth in claim 2, wherein channel regions of said first and second conductive type MISFETs are oriented in the same direction.

4. The semiconductor device as set forth in claim 3, wherein gate electrodes of said first and second conductive type MISFETs are disposed in parallel with each other.

5. The semiconductor device as set forth in any one of claims 2 to 4, wherein said basic cell includes a pair of MISFETs of at least any one of said first and second conductive types, and said pair of MISFETs share any one of source and drain regions with each other.

6. The semiconductor device as set forth in any one of claims 2 to 5, wherein said main MISFETs and said sub-MISFET share any one of source and drain regions thereof with each other.

7. The semiconductor device as set forth in any one of claims 2 to 6, wherein a channel width of said sub-MISFET is narrower than a channel width of said main MISFETs.

## Patentansprüche

1. Halbleitervorrichtung, umfassend:

   eine Mehrzahl einander benachbart angeordneter Basiszellen (1), wobei eine vorbestimmte Schaltung durch Intrabasiszellenverbindungen und Interbasiszellenverbindungen konfiguriert wird, wobei die Basiszelle aufweist:
   erste Haupt-MISFETs (11, 12), die parallel zueinander angeordnet sind,
   zweite Haupt-MISFETs (21, 22), die parallel zueinander und den ersten MISFETs benachbart angeordnet sind,
   eine erste Stopperschicht (16), die parallel zu den ersten Haupt-MISFETs angeordnet ist, um die ersten Haupt-MISFETs von ersten Haupt-MISFETs einer anderen benachbarten Basiszelle zu separieren,
   eine zweite Stopperschicht (26), die parallel zu den zweiten Haupt-MISFETs angeordnet ist, um die zweiten Haupt-MISFETs von zweiten Haupt-MISFETs der anderen benachbarten Basiszelle zu separieren, und
   einen Sub-MISFET (13) mit einer Fläche, die kleiner als diejenige der Haupt-MISFETs ist, und der in einem Bereich gebildet ist, der der anderen Basiszelle benachbart und einer Querseite der ersten Stopperschicht (16) benachbart ist,

   **dadurch gekennzeichnet**, daß die Querseite von der zweiten Stopperschicht (26) abgewandt ist, ein Gate-Kontaktabschnitt des Sub-MISFETs sowie Gate-Kontaktabschnitte der ersten Haupt-MISFETs kollinear angeordnet sind, und ein Stromversorgungskontaktabschnitt der ersten Stopperschicht (16) an der Querseite der ersten Stopperschicht (16) vorgesehen und kollinear zu Stromversorgungskontaktabschnitten von Source/Drain-Bereichen der ersten Haupt-MISFETs angeordnet ist.

**2.** Halbleitervorrichtung nach Anspruch 1, bei der die Basiszelle einen MISFET eines ersten Leitfähigkeitstyps, der mit zumindest einem Kanal erster Leitfähigkeit gebildet ist, und einen MISFET eines zweiten Leitfähigkeitstyps aufweist, der mit zumindest einem Kanal einer zweiten Leitfähigkeit gebildet ist, die Haupt-MISFETs MISFETs eines beliebigen des ersten und des zweiten Leitfähigkeitstyps sind, die erste und die zweite Stopperschicht Diffusionsschichten eines Leitfähigkeitstyps sind, der sich von demjenigen jeweiliger erster und zweiter Haupt-MISFETs unterscheidet, und der Sub-MISFET ein MISFET ist, der mit einem Kanal desselben Leitfähigkeitstyps wie derjenige der ersten Haupt-MISFETs gebildet ist.

**3.** Halbleitervorrichtung nach Anspruch 2, bei der Kanalbereiche der MISFETs des ersten und des zweiten Leitfähigkeitstyps in derselben Richtung orientiert sind.

**4.** Halbleitervorrichtung nach Anspruch 3, bei der Gate-Elektroden der MISFETs des ersten und des zweiten Leitfähigkeitstyps parallel zueinander angeordnet sind.

**5.** Halbleitervorrichtung nach einem der Ansprüche 2 bis 4, bei der die Basiszelle ein Paar MISFETs zumindest eines beliebigen des ersten und des zweiten Leitfähigkeitstyps aufweist und das Paar MISFETs einen beliebigen der Source- und Drain-Bereiche gemeinsam benutzen.

**6.** Halbleitervorrichtung nach einem der Ansprüche 2 bis 5, bei der die Haupt-MISFETS und der Sub-MISFET einen beliebigen ihrer Source- und Drain-Bereiche gemeinsam benutzen.

**7.** Halbleitervorrichtung nach einem der Ansprüche 2 bis 6, bei der die Kanalbreite des Sub-MISFET kleiner als die Kanalbreite der Haupt-MISFETs ist.

**Revendications**

**1.** Dispositif à semi-conducteurs comportant :

une pluralité de cellules (1) de base adjacentes les unes aux autres, dans lequel un circuit déterminé à l'avance est configuré par des connexions internes de cellules de base et des connexions entre ces cellules de base, la cellule de base comportant
des premiers MISFET (11, 12) principaux disposés parallèlement les uns aux autres,
des seconds MISFET (21, 22) principaux disposés parallèlement les uns aux autres et adjacents aux premiers MISFET,
une première couche (16) d'arrêt disposée parallèlement aux premiers MISFET principaux pour séparer les premiers MISFET principaux des premiers MISFET principaux d'une autre cellule de base adjacente,
une seconde couche (26) d'arrêt disposée parallèlement aux seconds MISFET principaux pour séparer les seconds MISFET principaux des seconds MISFET principaux de l'autre cellule de base adjacente, et
un sous-MISFET (13) ayant une aire plus petite que celle des MISFET principaux formé dans une région adjacente à l'autre cellule de base et adjacent à un côté latéral de la première couche (16) d'arrêt,

caractérisé en ce que le côté latéral est à distance de la seconde couche (26) d'arrêt, une partie de contact de grille du sous-MISFET et des parties de contact de grille des premiers MISFET principaux sont agencées de manière à être colinéaires, et une partie de contact d'alimentation en courant de la première couche (16) d'arrêt est prévue sur le côté latéral de la première couche (16) d'arrêt et agencée pour être colinéaire aux parties de contact d'alimentation en courant des régions de source/drain des premiers MISFET principaux.

**2.** Dispositif à semi-conducteurs suivant la revendication 1, dans lequel la cellule de base comporte un MISFET d'un premier type de conductivité formé par au moins un canal de première conductivité et un MISFET de second type de conductivité formé d'au moins un canal de second type de conductivité, les MISFET principaux sont des MISFET d'un type ou l'autre du premier et second types de conductivité, les première et seconde couches d'arrêt sont des couches de diffusion de type de conductivité différent de celui des premier et second MISFET principaux respectifs, et le sous-MISFET est un MISFET formé d'un canal ayant le même type de conductivité que celui des premiers MISFET principaux.

**3.** Dispositif à semi-conducteurs suivant la revendication 2, dans lequel des régions de canal des MISFET du premier et second types de conductivité sont orientés suivant la même direction.

**4.** Dispositif à semi-conducteurs suivant la revendication 3, dans lequel l'électrode de grille des MISFETs du premier et du second types de conductivité sont disposés parallèlement les uns aux autres.

**5.** Dispositif à semi-conducteurs suivant l'une quelconque des revendications 2 à 4, dans lequel la cellule de base comporte une paire de MISFET d'au moins n'importe lequel des premier et second types de conductivité, et les deux MISFET de la paire partage entre eux l'une quelconque de leurs régions de source et de drain.

**6.** Dispositif à semi-conducteurs suivant l'une quelconque des revendications 2 à 5, dans lequel les MISFET principaux et le sous-MISFET se partagent entre eux l'une quelconque de leurs régions de source et de drain.

**7.** Dispositif à semi-conducteurs suivant l'une quelconque des revendications 2 à 6, dans lequel une largeur de canal du sous-MISFET est plus étroite qu'une largeur de canal des MISFET principaux.

Fig. 1

the first layer wire

○ diffusion, viahole for connecting polysilicon to the first layer wire

Fig. 2

DATA LINE                                    BIT LINE        Fig. 3

W                    31          33          R

                                                    42        52

41      43          32

51

DATA LINE                                    BIT LINE    Fig. 4

                                        Vdd

41      44      46              48  42

                                        49

51          45  43      47

        52

            Vss

W                                           R

11

Fig. 5

Fig. 6

Fig. 7

Fig. 8

51 DATA LINE    51 DATA LINE

XW    W

26.1    16.1

23.1    )13.1
21.1    )11.1
1.1    W    XW
22.1    )12.1

23.2    )13.2
21.2    )11.2
1.2    XR    R    BIT LINE
22.2    )12.2

Pch    26.2    16.2    Nch    52

Vdd    Vss

―― the first layer wire

---- the second layer wire

○ diffusion, viahole for connecting polysilicon to the first
layer wire

⊙ viahole for connecting the first layer
to the second layer

Fig. 9

DATA LINE    BIT LINE

W    31    33    R

51    42

XR    52

41    XW    43    32

Fig. 10

Fig. 11

BIT LINE

Vdd          Vss

1.1

R

DATA LINE

1.2

W

1.3

Pch          Nch

—— the first layer wire

○ diffusion, viahole for connecting polysilicon to the first layer wire

Fig. 12

10

26          16
            14

21          11

24    25    15

22

24          12

24          14

H           H